(19) Europäisches Patentamt / European Patent Office / Office européen des brevets

(11) **EP 3 882 824 A1**

(12) **EUROPEAN PATENT APPLICATION**
published in accordance with Art. 153(4) EPC

(43) Date of publication:
**22.09.2021 Bulletin 2021/38**

(51) Int Cl.:
***G06N 3/08*** *(2006.01)*

(21) Application number: **19883762.7**

(22) Date of filing: **17.09.2019**

(86) International application number:
**PCT/CN2019/106084**

(87) International publication number:
**WO 2020/098368 (22.05.2020 Gazette 2020/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.11.2018 CN 201811358824**

(71) Applicant: **Canaan Bright Sight Co., Ltd.**
**Beijing 100094 (CN)**

(72) Inventors:
• **GUO, Hui**
 **Beijing 100094 (CN)**
• **ZHANG, Nangeng**
 **Beijing 100094 (CN)**

(74) Representative: **Loyer & Abello**
 **9, rue Anatole de la Forge**
 **75017 Paris (FR)**

(54) **ADAPTIVE QUANTIZATION METHOD AND APPARATUS, DEVICE AND MEDIUM**

(57) Provided are an adaptive quantization method and apparatus, a device and medium. The method comprises: respectively performing a first quantization processing on a plurality of original input tensors to obtain an input tensor in a fixed-point number form, and calculating a quantization offset of the input tensor in the fixed-point number form (S102); calculating a comprehensive quantization offset corresponding to the plurality of original input tensors, and an adaptive quantization coefficient (S104); according to the adaptive quantization coefficient and the comprehensive quantization offset, performing a second quantization process on the input tensor in the fixed-point number form and the quantization offset to obtain a quantization result (S106). The method is helpful to improve the quantization accuracy, improve the performance of the convolutional neural network, and reduce the hardware power consumption and design difficulty.

S102
Performing a first quantization on each of a plurality of original input tensors to acquire an input tensor in a fixed-point number format, and calculating a quantization offset of the input tensor in the fixed-point number format

S104
Calculating a global quantization offset corresponding to the plurality of original input tensors, and an adaptive quantization factor

S106
Performing a second quantization on the input tensor in the fixed-point number format and the quantization offset thereof based on the adaptive quantization factor and the global quantization offset to acquire a quantization result

FIG. 1

EP 3 882 824 A1

## Description

## TECHNICAL FIELD

The present disclosure relates to the field of machine learning technologies, and in particular to a method, an apparatus, a device, and a medium each for adaptive quantization.

## BACKGROUND

Convolutional neural network has achieved great breakthroughs in many fields such as computer vision, speech processing, machine learning, image recognition, and face recognition, which significantly improves performances of corresponding machine algorithms in various tasks such as image classification, target detection and speech recognition, and has been widely applied in industries such as Internet and video surveillance.

The convolutional neural network with a larger capacity and a higher complexity can learn data more comprehensively and thereby recognize the data more accurately. Of course, as the number of network layers and parameters increase, the costs in computation and storage may also increase significantly.

In the prior art, floating-point numbers are generally used directly for computation in data processing using the convolutional neural network. However, with this approach, the computation speed is slow and the hardware power consumption is high.

## SUMMARY

Embodiments of the present disclosure provide a method, an apparatus, a device, and a medium each for adaptive quantization to solve the technical problem in the prior art, which lies in the fact that the floating-point numbers are generally used directly for the convolution computation in data processing using the convolutional neural network, in which however the computation speed is low and the hardware power consumption is high.

The technical solutions adopted by embodiments of the present disclosure are as follows.

A method for adaptive quantization includes:

performing a first quantization on each of a plurality of original input tensors to acquire an input tensor in a fixed-point number format, and calculating a quantization offset of the input tensor in the fixed-point number format;

calculating a comprehensive quantization offset corresponding to the plurality of original input tensors, and an adaptive quantization factor; and

performing a second quantization on the input tensor in the fixed-point number format and the quantization offset thereof based on the adaptive quantization factor and the comprehensive quantization offset to acquire a quantization result.

Optionally, performing the first quantization on each of the plurality of original input tensors to acquire the input tensor in the fixed-point number format and calculating the quantization offset of the input tensor in the fixed-point number format specifically includes:

for each original input tensor among the plurality of original input tensors, determining an end value of said each original input tensor, performing the first quantization on said each original input tensor based on the end value to acquire the input tensor in the fixed-point number format, and calculating the quantization offset of the input tensor in the fixed-point number format.

Optionally, calculating the comprehensive quantization offset corresponding to the plurality of original input tensors, and the adaptive quantization factor specifically includes:

determining a comprehensive end value based on respective end values of the plurality of original input tensors;

calculating a comprehensive quantization scaling factor and the comprehensive quantization offset based on the comprehensive end value; and

calculating the adaptive quantization factor based on the comprehensive quantization scaling factor and a quantization scaling factor adopted in the first quantization.

Optionally, the plurality of original input tensors are from a same arithmetic logic unit (ALU), and the method is executed for each of a plurality of different ALUs.

Optionally, performing the first quantization on said each original input tensor based on the end value specifically includes:

performing the first quantization on said each original input tensor with a first function based on a minimum value that is the end value and a minimum value of a specified quantized value range,

where the first function includes a quantization scaling factor, and a conversion logic for converting floating-point numbers to fixed-point numbers.

Optionally, calculating the quantization offset of the input tensor in the fixed-point number format specifically includes:

calculating the quantization offset of the input tensor in the fixed-point number format with a second function based on the minimum value that is the end value and the minimum value of the specified quantized value range,

where the second function includes the quantization scaling factor, and the conversion logic for converting floating-point numbers to fixed-point numbers.

Optionally, the quantization scaling factor is calculated based on the end value of said each original input tensor and/or an end value of the specified quantized value range.

Optionally, calculating the comprehensive quantization scaling factor and the comprehensive quantization offset based on the comprehensive end value specifically includes:

calculating the comprehensive quantization scaling factor and the comprehensive quantization offset based on the comprehensive end value and the end value of the specified quantized value range.

Optionally, calculating the adaptive quantization factor based on the comprehensive quantization scaling factor and the quantization scaling factor adopted in the first quantization specifically includes:

> performing transformation on a proportional relationship between the comprehensive quantization scaling factor and the quantization scaling factor adopted in the first quantization by using a logarithmic coordinate system; and
> calculating at least one adaptive quantization factor based on the transformed proportional relationship; where the conversion logic for converting floating-point numbers to fixed-point numbers and/or a factor for preserving precision are adopted during the calculating.

Optionally, the quantization scaling factor is calculated according to Formula

$$S_{X_i} = \frac{Q_{high} - Q_{low}}{X_{maxi} - X_{mini}},$$

where $S_{X_i}$ represents the quantization scaling factor corresponding to said each original input tensor $X_i$, $Q_{low}$ represents the minimum value of the specified quantized value range, $Q_{high}$ represents a maximum value of the specified quantized value range, $X_{mini}$ represents the minimum value of $X_i$, and $X_{maxi}$ represents a maximum value of $X_i$.

Optionally, the first function is expressed by:

$$\dot{X}_1 = round\left[ S_{X_i} \cdot \left( X_i - X_{mini} \right) \right] + Q_{low};$$

where $\dot{X}_1$ represents a result of the first quantization performed on said each original input tensor $X_i$, $X_{mini}$ represents the minimum value of $X_i$, $S_{X_i}$ represents the quantization scaling factor corresponding to $X_i$, $Q_{low}$ represents the minimum value of the specified quantization range, and *round* represents a function for rounding floating-point numbers to fixed-point numbers.

Optionally, the second function is expressed by:

$$B_{X_i} = round\left[ -S_{X_i} \cdot X_{mini} \right] + Q_{low};$$

where $B_{X_i}$ represents the quantization offset calculated for a result of the first quantization performed on $X_i$, $X_{mini}$ represents the minimum value of $X_i$, $S_{X_i}$ represents the quantization scaling factor corresponding to $X_i$, $Q_{low}$ represents the minimum value of the quantized value range, and *round* represents the function for rounding floating-point numbers to fixed-point numbers.

Optionally, the at least one adaptive quantization factor includes a first adaptive quantization factor and a second adaptive quantization factor;

> the first adaptive quantization factor is calculated by performing transformation on the proportional relationship by using the logarithmic coordinate system and then performing precision adjustment by using the factor for preserving precision, and/or
> the second adaptive quantization factor is calculated by performing reverse transformation based on the proportional relationship and the first adaptive quantization factor by using an exponential coordinate system.

Optionally, the first quantization is performed based on a specified bit number of an *N*-nary number, and the first adaptive quantization factor $shift_i$ is calculated according to following Formula:

$$shift_i = ceil\left[ log_N\left( \frac{S_{X_i}}{S_y} \right) + \alpha \right];$$

where $S_{X_i}$ represents the quantization scaling factor corresponding to said each original input tensor $X_i$, $S_y$ represents the comprehensive quantization scaling factor, $\alpha$ represents an *N*-nary bit number expected to preserve the precision, and *ceil* represents a function for rounding up to the nearest integer.

Optionally, the first quantization is performed based on a specified bit number of an *N*-nary number, and the second adaptive quantization factor $r_i$ is calculated according to following Formula:

$$r_i = round\left( \frac{N^{shift_i} \cdot S_{X_i}}{S_y} \right);$$

where $S_{X_i}$ represents the quantization scaling factor corresponding to said each original input tensor $X_i$, $S_y$ represents the comprehensive quantization scaling factor, $shift_i$ represents the first adaptive quantization factor, and *round* represents the function for rounding floating-point numbers to fixed-point numbers.

Optionally, the first quantization is performed according to a specified bit number of an *N*-nary number, and performing the second quantization on the input tensor in the fixed-point number format and the quantization offset thereof based on the adaptive quantization factor and the comprehensive quantization offset to acquire the quantization result specifically includes:

performing the second quantization on the input tensor in the fixed-point number format and the quantization offset thereof according to following Formula to acquire the quantization result $\dot{Y}_1$:

$$\dot{Y}_1 = \frac{r_i \cdot \left( \dot{X}_1 - B_{X_i} \right)}{N^{shift_i}} + B_y \; ;$$

where $shift_i$ represents the first adaptive quantization factor, $r_i$ represents the second adaptive quantization factor, $\dot{X}_1$ represents a result of the first quantization performed on said each original input tensor $X_i$, $B_{X_i}$ represents the quantization offset calculated for the result of the first quantization performed on $X_i$, and $B_y$ represents the comprehensive quantization offset.

An apparatus for adaptive quantization includes:

a first quantization module configured to perform a first quantization on each of a plurality of original input tensors to acquire an input tensor in a fixed-point number format, and calculate a quantization offset of the input tensor in the fixed-point number format;
an adaptive-quantization-factor calculation module configured to calculate a comprehensive quantization offset corresponding to the plurality of original input tensors, and an adaptive quantization factor; and
a second quantization module configured to perform a second quantization on the input tensor in the fixed-point number format and the quantization offset thereof based on the adaptive quantization factor and the comprehensive quantization offset to acquire a quantization result.

Optionally, performing, by the first quantization module, the first quantization on each of the plurality of original input tensors to acquire the input tensor in the fixed-point number format and calculating the quantization offset of the input tensor in the fixed-point number format specifically includes:
for each original input tensor among the plurality of original input tensors, determining, by the first quantization module, an end value of said each original input tensor, performing the first quantization on said each original input tensor based on the end value to acquire the input tensor in the fixed-point number format, and calculating the quantization offset of the input tensor in the fixed-point number format.
Optionally, calculating, by the adaptive-quantization-factor calculation module, the comprehensive quantization offset corresponding to the plurality of original input tensors, and the adaptive quantization factor specifically includes:

determining, by the adaptive-quantization-factor calculation module, a comprehensive end value based on respective end values of the plurality of original input tensors;
calculating a comprehensive quantization scaling factor and the comprehensive quantization offset based on the comprehensive end value; and
calculating the adaptive quantization factor based on the comprehensive quantization scaling factor and a quantization scaling factor adopted in the first quantization.

Optionally, the plurality of original input tensors are from a same arithmetic logic unit (ALU), and the apparatus is configured for each of a plurality of different ALUs.
Optionally, performing, by the first quantization module, the first quantization on said each original input tensor based on the end value specifically includes:

performing, by the first quantization module, the first quantization on said each original input tensor with a first function based on a minimum value that is the end value and a minimum value of a specified quantized value range,
where the first function includes a quantization scaling factor, and a conversion logic for converting floating-point numbers to fixed-point numbers.

Optionally, calculating, by the first quantization module, the quantization offset of the input tensor in the fixed-point number format specifically includes:

calculating, by the first quantization module, the quantization offset of the input tensor in the fixed-point number format with a second function based on the minimum value that is the end value and the minimum value of the specified quantized value range,
where the second function includes the quantization scaling factor, and the conversion logic for converting floating-point numbers to fixed-point numbers.

Optionally, the quantization scaling factor is calculated based on the end value and/or an end value of the specified quantized value range.
Optionally, calculating, by the adaptive-quantization-factor calculation module, the comprehensive quantization scaling factor and the comprehensive quantization offset based on the comprehensive end value specifically includes:
calculating, by the adaptive-quantization-factor calculation module, the comprehensive quantization scaling factor and the comprehensive quantization offset based on the comprehensive end value and the end value of the specified quantized value range.

Optionally, calculating, by the adaptive-quantization-factor calculation module, the adaptive quantization factor based on the comprehensive quantization scaling factor and the quantization scaling factor adopted in the first quantization specifically includes:

performing, by the adaptive-quantization-factor calculation module, transformation on a proportional relationship between the comprehensive quantization scaling factor and the quantization scaling factor adopted in the first quantization by using a logarithmic coordinate system; and calculating at least one adaptive quantization factor based on the transformed proportional relationship; where the conversion logic for converting floating-point numbers to fixed-point numbers and/or a factor for preserving precision are adopted during the calculating.

Optionally, the quantization scaling factor is calculated according to Formula

$$S_{X_i} = \frac{Q_{high} - Q_{low}}{X_{maxi} - X_{mini}}$$,

where $S_{X_i}$ represents the quantization scaling factor corresponding to said each original input tensor $X_i$, $Q_{low}$ represents the minimum value of the specified quantized value range, $Q_{high}$ represents a maximum value of the specified quantized value range, $X_{mini}$ represents the minimum value of $X_i$, and $X_{maxi}$ represents a maximum value of $X_i$.

Optionally, the first function is expressed by:

$$\dot{X}_1 = round \left[ S_{X_i} \cdot \left( X_i - X_{mini} \right) \right] + Q_{low};$$

where $\dot{X}_1$ represents a result of the first quantization performed on said each original input tensor $X_i$, $X_{mini}$ represents the minimum value of $X_i$, $S_{X_i}$ represents the quantization scaling factor corresponding to $X_i$, $Q_{low}$ represents the minimum value of the specified quantization range, and *round* represents a function for rounding floating-point numbers to fixed-point numbers.

Optionally, the second function is expressed by:

$$B_{X_i} = round \left[ -S_{X_i} \cdot X_{mini} \right] + Q_{low};$$

where $B_{X_i}$ represents the quantization offset calculated for a result of the first quantization performed on $X_i$, $X_{mini}$ represents the minimum value of $X_i$, $S_{X_i}$ represents the quantization scaling factor corresponding to $X_i$, $Q_{low}$ represents the minimum value of the quantized value range, and *round* represents the function for rounding floating-point numbers to fixed-point numbers.

Optionally, the at least one adaptive quantization factor includes a first adaptive quantization factor and a second adaptive quantization factor;

the first adaptive quantization factor is calculated by the adaptive-quantization-factor calculation module performing transformation on the proportional relationship by using the logarithmic coordinate system and then performing precision adjustment by using the factor for preserving precision, and/or the second adaptive quantization factor is calculated by the adaptive-quantization-factor calculation module performing reverse transformation based on the proportional relationship and the first adaptive quantization factor by using an exponential coordinate system.

Optionally, the first quantization is performed based on a specified bit number of an $N$-nary number, and the first adaptive quantization factor $shift_i$ is calculated by the adaptive-quantization-factor calculation module according to following Formula:

$$shift_i = ceil \left[ log_N \left( \frac{S_{X_i}}{S_y} \right) + \alpha \right];$$

where $S_{X_i}$ represents the quantization scaling factor corresponding to said each original input tensor $X_i$, $S_y$ represents the comprehensive quantization scaling factor, $\alpha$ represents an $N$-nary bit number expected to preserve the precision, and *ceil* represents a function for rounding up to the nearest integer.

Optionally, the first quantization is performed based on a specified bit number of the $N$-nary number, and the second adaptive quantization factor $r_i$ is calculated by the adaptive-quantization-factor calculation module according to following Formula:

$$r_i = round \left( \frac{N^{shift_i} \cdot S_{X_i}}{S_y} \right);$$

where $S_{X_i}$ represents the quantization scaling factor corresponding to said each original input tensor $X_i$, $S_y$ represents the comprehensive quantization scaling factor, $shift_i$ represents the first adaptive quantization factor, and *round* represents the function for rounding floating-point numbers to fixed-point numbers.

Optionally, the first quantization is performed according to a specified bit number of an $N$-nary number, and performing, by the second quantization module, the second quantization on the input tensor in the fixed-point number format and the quantization offset thereof based on the adaptive quantization factor and the comprehensive quantization offset to acquire the quantization result specifically includes:

performing, by the second quantization module, the second quantization on the input tensor in the fixed-point number format and the quantization offset thereof according to following Formula to acquire the quantization result $\dot{Y}_1$:

$$\dot{Y}_1 = \frac{r_i' \cdot \left( \dot{X}_1 - B_{X_i} \right)}{N^{shift_i}} + B_y ;$$

where $shift_i$ represents the first adaptive quantization factor, $r_i'$ represents the second adaptive quantization factor, $\dot{X}_1$ represents a result of the first quantization performed on said each original input tensor $X_i$, $B_{X_i}$, represents the quantization offset calculated for the result of the first quantization performed on $X_i$, and $B_y$ represents the comprehensive quantization offset.

A device for adaptive quantization includes:

at least one processor; and
a memory communicatively connected to the at least one processor;
where the memory has stored therein instructions executable by the at least one processor, the instructions, when executed by the at least one processor, causing the at least one processor to:

perform a first quantization on each of a plurality of original input tensors to acquire an input tensor in a fixed-point number format, and calculate a quantization offset of the input tensor in the fixed-point number format;
calculate a comprehensive quantization offset corresponding to the plurality of original input tensors, and an adaptive quantization factor; and
perform a second quantization on the input tensor in the fixed-point number format and the quantization offset thereof based on the adaptive quantization factor and the comprehensive quantization offset to acquire a quantization result.

A non-volatile computer storage medium for adaptive quantization has stored therein computer-executable instructions, the computer-executable instructions being configured to:

perform a first quantization on each of a plurality of original input tensors to acquire an input tensor in a fixed-point number format, and calculate a quantization offset of the input tensor in the fixed-point number format;

calculate a comprehensive quantization offset corresponding to the plurality of original input tensors, and an adaptive quantization factor; and

perform a second quantization on the input tensor in the fixed-point number format and the quantization offset thereof based on the adaptive quantization factor and the comprehensive quantization offset to acquire a quantization result.

According to at least one technical solution provided in embodiments of the present disclosure, the conversion logic for converting floating-point numbers to fixed-point numbers is used and the adaptive quantization enables at least part of the steps thereof to be executed in parallel in blocks, whereby beneficial effects of facilitating improvement of the quantization accuracy and performance of the convolutional neural network, and reduction of the power consumption and design difficulty of the hardware can be achieved.

**BRIEF DESCRIPTION OF THE DRAWINGS**

Here, the accompanying drawings are illustrated to provide further understanding of the present disclosure, which constitute a part of the specification. The exemplary embodiments of the present disclosure and the description thereof are used to explain the present disclosure, and do not constitute improper limit to the present disclosure. In the accompanying drawings:

FIG. 1 is a schematic flowchart of a method for adaptive quantization according to some embodiments of the present disclosure;

FIG. 2 is a detailed flowchart of the method for adaptive quantization in FIG. 1 according to some embodiments of the present disclosure;

FIG. 3 is a schematic structural diagram of an apparatus for adaptive quantization corresponding to FIG. 1 according to some embodiments of the present disclosure; and

FIG. 4 is a schematic structural diagram of a device for adaptive quantization corresponding to FIG. 1 according to some embodiments of the present disclosure.

**DETAILED DESCRIPTION**

In order to make the objects, technical solutions and advantages of the present disclosure more clearly, the technical solutions of the present disclosure will be clearly and completely described below in conjunction with embodiments and corresponding drawings of the present disclosure. It is apparent that the described embodiments are merely a part but not all of the embodiments of the present disclosure. All the other embodiments achieved by a person of ordinary skill in the art, based on the embodiments of the present disclosure without creative effort, shall fall within the protection scope of the present disclosure.

At present, the convolutional neural network is commonly used for image processing and may perform complex computations during the processing, which mainly includes convolution computation, batch normalization computation, activation computation, and the like. The present disclosure provides adaptive quantization solutions, in which the aforesaid computations can be performed after simplifying the original data, rather than performed directly with the floating-point numbers. The solutions of the present disclosure will be described hereinafter in detail.

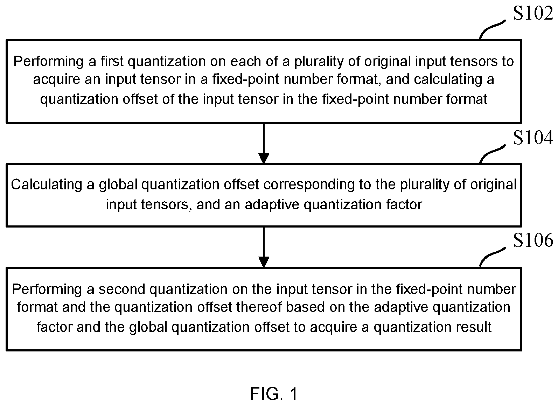

FIG. 1 is a schematic flowchart of a method for adaptive quantization according to some embodiments of the present disclosure. In this flow, the execution body, from an device perspective, may be one or more computing devices, such as a single machine learning server, a machine learning server cluster, or the like based on a convolutional neural network. Correspondingly, the execution body, from a program perspective, may be a program carried on the computing devices, such as a neural network modeling platform, an image processing platform, or the like based on a convolutional neural network, or may specifically be one or more neurons included in the convolutional neural network applied on this type of platform.

The flow in FIG. 1 may include following steps.

S102: a first quantization is performed on each of a plurality of original input tensors to acquire an input tensor in a fixed-point number format, and a quantization offset of the input tensor in the fixed-point number format is calculated.

In some embodiments of the present disclosure, the specific implementation manners of the first quantization may be various, such as, performing uniform quantization based on the end value of each original input tensor, performing non-uniform quantization based on distribution of each original input tensor, or the like.

S104: a comprehensive quantization offset corresponding to the plurality of original input tensors, and an adaptive quantization factor are calculated.

In some embodiments of the present disclosure, the comprehensive quantization offset may be calculated based on the quantization offset of each input tensor in the fixed-point number format as acquired in step S102, or may be calculated at least not entirely dependent on the quantization offset but based on other parameters, such as the end value of each original input tensor and the like.

S106: a second quantization is performed on the input tensor in the fixed-point number format and the quantization offset thereof based on the adaptive quantization factor and the comprehensive quantization offset to acquire a quantization result.

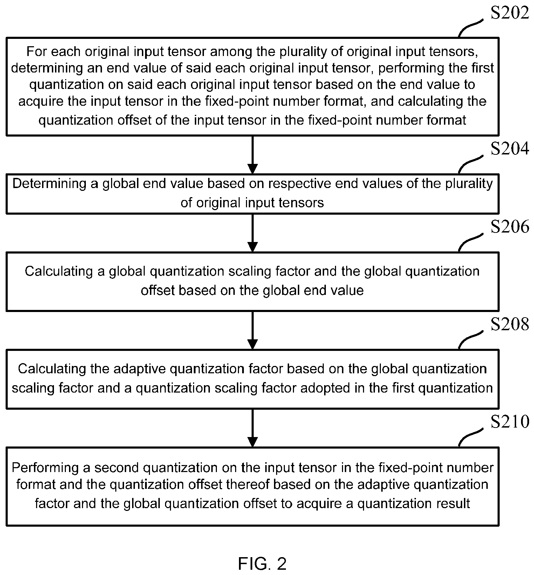

More particularly, as shown in FIG. 2, some embodiments of the present disclosure further provide a detailed flowchart of the method for adaptive quantization in FIG. 1.

The flow in FIG. 2 may include following steps.

S202: for each original input tensor among the plurality of original input tensors, an end value of said each original input tensor is determined, the first quantization is performed on said each original input tensor based on the end value to acquire the input tensor in the fixed-point number format, and the quantization offset of the input tensor in the fixed-point number format is calculated.

In some embodiments of the present disclosure, for the convolutional neural network, the original input tensor is generally expressed as a vector or matrix, and the elements therein are generally in floating-point format. The original input tensor may be the input of the entire convolutional neural network, the input of any neuron in the convolutional neural network, or the intermediate output of the processing logic in any neuron, etc.

For the convenience of description, some following embodiments are described by mainly taking the following scenario as an example. The device running the convolutional neural network includes a plurality of arithmetic logic units (ALU). The ALU may perform conventional computations in the convolutional neural network, and the data output by each ALU in one or more specified computation stages may be taken as the original input tensor. The flow in FIG. 1 may be executed for each of a plurality of different ALUs. Correspondingly, the plurality of original input tensors in step S202 are from the same ALU. In step S202, some operations in the solution of the present disclosure may be separately executed in parallel for the plurality of original input tensors, which can accelerate the overall processing speed and thereby cause a rather high efficiency.

In some embodiments of the present disclosure, the original input tensor that may be in floating-point format may be simplified by performing some approximate processing through the first quantization. The approximate processing at least includes quantization during which a processing of converting floating-point numbers to fixed-point numbers is further performed. During the first quantization, the quantization is implemented with a corresponding quantization scaling factor. Of course, some additional items or factors may further be used for additional adjustment.

In some embodiments of the present disclosure, the quantization scaling factor mainly determines the conversion scale for the object to be quantized, and there may be various methods for calculating the quantization scaling factor. For example, the quantization scaling factor may be calculated based on a specified quantized value range and/or a value range of the object to be quantized per se. There may also be various conversion logics for converting floating-point numbers to fixed-point numbers, and the conversion may for example be performed by rounding or directly rounding down, etc.

In some embodiments of the present disclosure, the quantization offset may be dynamically changed in adaptive to the current original input tensor. The quantization offset is adopted to further adaptively adjust the preliminary quantization result acquired by the first quantization in step S102, such that the quantization result acquired after the adjustment is closer to the original data, thereby helping to improve the computation accuracy. There may be various methods for calculating the quantization offset. For example, the quantization offset may be calculated based on the quantization scaling factor and/or the specified quantized value range and/or the value range of the object to be quantized per se.

S204: a comprehensive end value is determined based on respective end values of the plurality of original input tensors.

In some embodiments of the present disclosure, the dimensions of the plurality of original input tensors may be normalized by step S204 and subsequent steps, such that a more accurate quantitative result can be obtained based on the result of the normalized dimensions.

In some embodiments of the present disclosure, the end value may specifically refer to the maximum value and/or the minimum value. The comprehensive end value of the plurality of original input tensors corresponding to each ALU may be calculated, respectively. For the convenience of description, the value range corresponding to the comprehensive end value may be referred to as a partial value range. The "entire" relative to the "partial" here may refer to all the original input tensors corresponding to all ALUs.

There may be various methods for determining the comprehensive end value. For example, an end value of the value range consisting of respective end values of the plurality of original input tensors may directly be taken as the comprehensive end value; or an average value of the respective end values of the plurality of original input tensors may be taken as the comprehensive end value, etc.

S206: a comprehensive quantization scaling factor and the comprehensive quantization offset is calculated based on the comprehensive end value.

In some embodiments of the present disclosure, the end value in step S202 may be replaced with the comprehensive end value, and then the comprehensive quantization scaling factor and the comprehensive quantization offset may be calculated with reference to the solution in step S202. Alternatively, the calculation may be executed by a solution different from that in step S202.

S208: the adaptive quantization factor is calculated based on the comprehensive quantization scaling factor and a quantization scaling factor adopted in the first quantization.

In some embodiments of the present disclosure, the approximate processing may be performed during the process of calculating the adaptive quantization factor after the dimension is normalized to thereby control the quantization accuracy more accurately. There may be at least one adaptive quantization factor.

S210: a second quantization is performed on the input tensor in the fixed-point number format and the quantization offset thereof based on the adaptive quantization factor and the comprehensive quantization offset to acquire a quantization result.

In some embodiments of the present disclosure, the first quantization and the second quantization as performed are equivalent to quantizing the original input tensor in two steps, which, compared with completing the quantization in one step, helps to reduce the loss of quantization accuracy and improve the performance of the algorithm when the quantization bit number is limited.

According to the method according to FIG. 1 and FIG. 2, the conversion logic for converting floating-point numbers to fixed-point numbers is used, and the adaptive quantization enables at least part of the steps thereof to be executed in parallel in blocks, which facilitates improvement of the quantization accuracy and performance of the convolutional neural network, and reduction of power consumption and design difficulty of the hardware.

Based on the method according to FIG. 1 and FIG. 2, some embodiments of the present disclosure further provide some specific implementation solutions and extension solutions of the method, which will be described below.

In some embodiments of the present disclosure, the end value includes at least one of the minimum value and the maximum value, which may be determined by traversing each element in the original input tensor. The smallest element may be taken as the minimum value, and the largest element may be taken as the maximum value.

In some embodiments of the present disclosure, the end value of the quantized value range is calculated based on a specified quantization bit number. The quantization bit number is generally a binary number, which may for example be binary numbers such as 8-bit, 16-bit, or 32-bit. In general, the higher the number of bits, the higher the accuracy of quantization.

It is assumed below that the first quantization is performed based on the specified bit number of the $N$-nary number, and the specified quantization bit number is the quantization bit number $w$ of the $N$-nary number. For example, the end value of the quantized value range may be calculated according to following Formula: $Q_{low}=-N^{w-1}$ and $Q_{high} = N^{w-1}-1$, where $Q_{low}$ represents the minimum value of the specified quantized value range, $Q_{high}$ represents the maximum value of the specified quantized value range, and $N$ is generally 2. The negative value is considered in this example. In practical applications, it is also possible to merely consider the value range of positive values.

In some embodiments of the present disclosure, the quantization scaling factor may be calculated based on uniform quantization or non-uniform quantization. Herein, the uniform quantization is taken as an example for the calculation.

Assuming that there are $M$ quantization modules for each ALU to process in parallel respective original input tensors output by the ALU, the output of the current input $i^{th}$ ALU is denoted as the original input tensor $X_i$, the minimum and maximum values acquired by traversing $X_i$ are denoted as $X_{mini}$ and $X_{maxi}$ respectively, and the quantization scaling factor (denoted as $S_{X_i}$ corresponding to $X_i$ may for example be calculated according to Formula

$$S_{X_i} = \frac{Q_{high} - Q_{low}}{X_{maxi} - X_{mini}}.$$

If the quantization scaling factor is defined based on non-uniform quantization, additional factors or items containing the current $X_i$ may for example be added to the Formula in the above example. Some of the parameters in the aforesaid example may further be used hereinafter. For the sake of brevity, the meaning of the parameters will not be repeated.

In some embodiments of the present disclosure, step S202 of performing the first quantization on said each original input tensor based on the end value specifically includes: performing the first quantization on said each original input tensor with a first function based on a minimum value that is the end value and a minimum value of a specified quantized value range, where the first function includes a corresponding quantization scaling factor, and a conversion logic for converting floating-point numbers to fixed-point numbers. Furthermore, calculating the quantization offset of the input tensor in the fixed-point number format specifically includes: calculating the quantization offset of the input tensor in the fixed-point number format with a second function based on the minimum value that is the end value and the minimum value of the specified quantized value range, where the second function includes the corresponding quantization scaling factor, and the conversion logic for converting floating-point numbers to fixed-point numbers.

In some embodiments of the present disclosure, the first function and/or the second function, besides the corresponding quantization scaling factor, may further include other factors such as the minimum value of the quantized value range and the minimum value of the object to be quantized.

More intuitively, the present disclosure provides an example of a first function and a second function applicable to an actual application scenario.

The first function may for example be expressed as:

$$\dot{X}_1 = round\left[S_{X_i} \cdot (X_i - X_{mini})\right] + Q_{low};$$

the second function may for example be expressed as:

$$B_{X_i} = round\left[-S_{X_i} \cdot X_{mini}\right] + Q_{low};$$

where $\dot{X}_1$ represents a result of the first quantization performed on $X_i$, $round$ represents a function of rounding floating-point numbers to fixed-point numbers, and $B_{X_i}$ represents a quantization offset calculated for the result of the first quantization performed on $\dot{X}_1$. The $round$ may be replaced by other functions that can convert floating-point numbers to fixed-point numbers.

In some embodiments of the present disclosure, the respective processing results of the plurality of original input tensors are obtained via step S202. It is assumed that the subsequent steps are executed by a functional logic layer that can realize normalized dimensions, which is called Same Layer. For a certain ALU, assuming that there are $M$ quantization modules for processing the original input tensors, the input tensors in the fixed-point number format as acquired are denoted as $\dot{X}_1 \sim \dot{X}_M$ respectively, the quantization offsets as calculated are denoted as $B_{X_1} \sim B_{X_M}$ respectively, the minimum values of respective original input tensors are denoted as $X_{min1} \sim X_{minM}$ respectively, the maximum values are denoted as $X_{max1} \sim X_{maxM}$ respectively, and the corresponding quantization scaling factors of respective original input tensors are denoted as $S_{X_1} \sim S_{X_M}$ respectively, the aforesaid data are input to the Same Layer for processing, the specific processing process of which is shown in some embodiments below.

The minimum value acquired by traversing $X_{min1} \sim X_{minM}$ may be taken as the comprehensive minimum value and is denoted as $Y_{min}$. The maximum value as acquired by traversing $X_{max1} \sim X_{maxM}$ may be taken as the comprehensive minimum value and is denoted as $Y_{max}$. The comprehensive minimum value and comprehensive maximum value constitute the comprehensive end value.

Furthermore, step S206 of calculating the comprehensive quantization scaling factor and the comprehensive quantization offset based on the comprehensive end value specifically includes calculating the comprehensive quantization scaling factor and the comprehensive quantization offset based on the comprehensive end value and the end value of the specified quantized value range. For example, the comprehensive quantization scaling factor denoted as $S_y$ may be calculated according

$$S_y = \frac{Q_{high} - Q_{low}}{Y_{max} - Y_{min}}$$

to Formula , and the comprehensive quantization offset denoted as $B_y$ may be calculated according to Formula $B_y = round[-S_y \cdot Y_{min}] + Q_{low}$.

In some embodiments of the present disclosure, step S208 of calculating the adaptive quantization factor based on the comprehensive quantization scaling factor and the quantization scaling factor adopted in the first quantization specifically includes: performing transformation on a proportional relationship between the comprehensive quantization scaling factor and the quantization scaling factor adopted in the first quantization by using a logarithmic coordinate system, and calculating at least one adaptive quantization factor based on the transformed proportional relationship, where the conversion logic for converting floating-point numbers to fixed-point numbers and/or a factor for preserving precision are adopted during the calculating.

Furthermore, it is assumed that a plurality of adaptive quantization factors are acquired by the calculation, which includes the first adaptive quantization factor and the second adaptive quantization factor. Then, the first adaptive quantization factor is calculated by performing transformation on the proportional relationship by using the logarithmic coordinate system (solving for the logarithm) and then adjusting the accuracy by using the factor for preserving precision; and/or the second adaptive quantization factor is calculated by performing reverse transformation based on the proportional relationship and the first adaptive quantization factor by using the exponential coordinate system (solving for exponent).

For example, assuming that the first quantization is performed based on a specified bit number of an $N$-nary number, the first adaptive quantization factor, denoted as $shift_i$, may be calculated according to following Formula:

$$shift_i = ceil \left[ log_N \left( \frac{S_{X_i}}{S_y} \right) + \alpha \right];$$

the second adaptive quantization factor, denoted as $r_i$, may be calculated according to following Formula:

$$r_i = round \left( \frac{N^{shift_i} \cdot S_{X_i}}{S_y} \right);$$

where $\alpha$ represents an $N$-nary bit number expected to preserve the precision, which may be any natural number, and $ceil$ represents a function for rounding up to the nearest integer.

Furthermore, step S210 of performing the second quantization on the input tensor in the fixed-point number format and the quantization offset thereof based on the adaptive quantization factor and the comprehensive quantization offset to acquire the quantization result specifically includes: performing the second quantization on the input tensor in the fixed-point number format and the quantization offset thereof according to following Formula to acquire the quantization result denoted as $\dot{Y}_1$:

$$\dot{Y}_1 = \frac{r_i \cdot \left( \dot{X}_1 - B_{X_i} \right)}{N^{shift_i}} + B_y;$$

where $\dot{X}_1 - B_{X_i}$ may represent the preliminary quantization result acquired by performing the first quantization on $X_i$ and adjusting with the corresponding quantization offset. Further, the preliminary quantization result is scaled with the adaptive quantization factor and then adjusted with the comprehensive quantization offset to acquire $\dot{Y}_1$, which may be taken as the final quantization result.

It should be noted that some formulas listed above may reflect the concept of the solution of the present disclosure, but are not the only implementation manner. Based on the concept of the solution of the present disclosure, some more similar formulas may be acquired to replace the formulas listed above.

Based on the same concept, some embodiments of the present disclosure further provide an apparatus, a device, and a non-volatile computer storage medium corresponding to the aforesaid method.

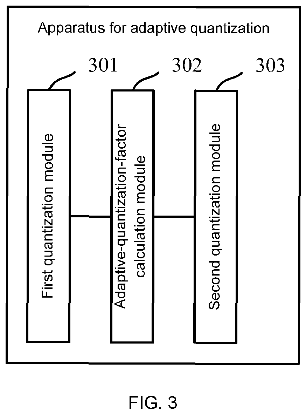

FIG. 3 is a schematic structural diagram of an apparatus for adaptive quantization corresponding to FIG. 1 according to some embodiments of the present disclosure. The apparatus includes:

a first quantization module 301 configured to perform a first quantization on each of a plurality of original input tensors to acquire an input tensor in a fixed-point number format, and calculate a quantization offset of the input tensor in the fixed-point number format;

an adaptive-quantization-factor calculation module 302 configured to calculate a comprehensive quantization offset corresponding to the plurality of original input tensors, and an adaptive quantization factor; and

a second quantization module 303 configured to perform a second quantization on the input tensor in the fixed-point number format and the quantization offset thereof based on the adaptive quantization factor and the comprehensive quantization offset to acquire a quantization result.

Optionally, performing, by the first quantization module 301, the first quantization on each of the plurality of original input tensors to acquire the input tensor in the fixed-point number format and calculating the quantization offset of the input tensor in the fixed-point number format specifically includes:

for each original input tensor among the plurality of original input tensors, determining, by the first quantization module 301, an end value of said each original input tensor, perform the first quantization on said each original input tensor based on the end value to acquire the input tensor in the fixed-point number format, and calculate the quantization offset of the input tensor in the fixed-point number format.

Optionally, calculating, by the adaptive-quantization-factor calculation module 302, the comprehensive quantization offset corresponding to the plurality of original input tensors, and the adaptive quantization factor specifically includes:

determining, by the adaptive-quantization-factor calculation module 302, a comprehensive end value based on respective end values of the plurality of original input tensors;

calculating a comprehensive quantization scaling factor and the comprehensive quantization offset based on the comprehensive end value; and

calculating the adaptive quantization factor based on the comprehensive quantization scaling factor and a quantization scaling factor adopted in the first quantization.

Optionally, the plurality of original input tensors are from a same arithmetic logic unit (ALU), and the apparatus is configured for each of a plurality of different ALUs.

Optionally, performing, by the first quantization module 301, the first quantization on said each original input tensor based on the end value specifically includes:

performing, by the first quantization module 301, the first quantization on said each original input tensor with a first function based on a minimum value that is the end value and a minimum value of a specified quantized value range,

where the first function includes a quantization scaling factor, and a conversion logic for converting floating-point numbers to fixed-point numbers.

Optionally, calculating, by the first quantization module 301, the quantization offset of the input tensor in the fixed-point number format specifically includes:

calculating, by the first quantization module 301, the quantization offset of the input tensor in the fixed-point number format with a second function based on the minimum value that is the end value and the minimum value of the specified quantized value range,

where the second function includes the quantization scaling factor, and the conversion logic for converting floating-point numbers to fixed-point numbers.

Optionally, the quantization scaling factor is calculated based on the end value and/or an end value of the specified quantized value range.

Optionally, calculating, by the adaptive-quantization-factor calculation module 302, the comprehensive quantization scaling factor and the comprehensive quantization offset based on the comprehensive end value specifically includes:

calculating, by the adaptive-quantization-factor calculation module 302, the comprehensive quantization scaling factor and the comprehensive quantization offset based on the comprehensive end value and the end value of the specified quantized value range.

Optionally, calculating, by the adaptive-quantization-factor calculation module 302, the adaptive quantization factor based on the comprehensive quantization scaling factor and the quantization scaling factor adopted in the first quantization specifically includes:

performing, by the adaptive-quantization-factor calculation module 302, transformation on a proportional relationship between the comprehensive quantization scaling factor and the quantization scaling factor adopted in the first quantization by using a logarithmic coordinate system; and

calculating at least one adaptive quantization factor based on the transformed proportional relationship; where the conversion logic for converting floating-point numbers to fixed-point numbers and/or a factor for preserving precision are adopted during the calculating.

Optionally, the quantization scaling factor is cal-

$$S_{X_i} = \frac{Q_{high} - Q_{low}}{X_{maxi} - X_{mini}}$$

culated according to Formula, where $S_{X_i}$ represents the quantization scaling factor corresponding to said each original input tensor $X_i$, $Q_{low}$ represents the minimum value of the specified quantized value range, $Q_{high}$ represents a maximum value of the specified quantized value range, $X_{mini}$ represents the minimum value of $X_i$, and $X_{maxi}$ represents a maximum value of $X_i$.

Optionally, the first function is expressed by:

$$\dot{X}_1 = round\left[ S_{X_i} \cdot \left( X_i - X_{mini} \right) \right] + Q_{low};$$

where $\dot{X}_1$ represents a result of the first quantization performed on said each original input tensor $X_i$, $X_{mini}$ represents the minimum value of $X_i$, $S_{X_i}$ represents the quantization scaling factor corresponding to $X_i$, $Q_{low}$ represents the minimum value of the specified quantization range, and *round* represents a function for rounding floating-point numbers to fixed-point numbers.

Optionally, the second function is expressed by:

$$B_{X_i} = round\left[ -S_{X_i} \cdot X_{mini} \right] + Q_{low};$$

where $B_{X_i}$ represents the quantization offset calculated for a result of the first quantization performed on $X_i$, $X_{mini}$

represents the minimum value of $X_i$, $S_{X_i}$ represents the quantization scaling factor corresponding to $X_i$, $Q_{low}$ represents the minimum value of the quantized value range, and *round* represents the function for rounding floating-point numbers to fixed-point numbers.

Optionally, the at least one adaptive quantization factor includes a first adaptive quantization factor and a second adaptive quantization factor,

> where the first adaptive quantization factor is calculated by the adaptive-quantization-factor calculation module 302 performing transformation on the proportional relationship by using the logarithmic coordinate system and then performing precision adjustment by using the factor for preserving precision, and/or
> the second adaptive quantization factor is calculated by the adaptive-quantization-factor calculation module 302 performing reverse transformation based on the proportional relationship and the first adaptive quantization factor by using an exponential coordinate system.

Optionally, the first quantization is performed based on a specified bit number of an $N$-nary number, and the first adaptive quantization factor *shift$_i$* is calculated by the adaptive-quantization-factor calculation module 302 according to following Formula:

$$shift_i = ceil\left[ log_N\left( \frac{S_{X_i}}{S_y} \right) + \alpha \right];$$

where $S_{X_i}$ represents the quantization scaling factor corresponding to said each original input tensor $X_i$, $S_y$ represents the comprehensive quantization scaling factor, $\alpha$ represents an $N$-nary bit number expected to preserve the precision, and *ceil* represents a function for rounding up to the nearest integer.

Optionally, the first quantization is performed based on a specified bit number of an N-nary number, and the second adaptive quantization factor $r_i$ is calculated by the adaptive-quantization-factor calculation module 302 according to following Formula:

$$r_i = round\left( \frac{N^{shift_i} \cdot S_{X_i}}{S_y} \right);$$

where $S_{X_i}$ represents the quantization scaling factor corresponding to said each original input tensor $X_i$, $S_y$ represents the comprehensive quantization scaling factor, *shift$_i$* represents the first adaptive quantization factor, and *round* represents the function for rounding floating-point numbers to fixed-point numbers.

Optionally, the first quantization is performed according to a specified bit number of an $N$-nary number, and performing, by the second quantization module 303, the second quantization on the input tensor in the fixed-point number format and the quantization offset thereof based on the adaptive quantization factor and the comprehensive quantization offset to acquire the quantization result specifically includes:

performing, by the second quantization module 303, the second quantization on the input tensor in the fixed-point number format and the quantization offset thereof according to following Formula to acquire the quantization result $\dot{Y}_1$:

$$\dot{Y}_1 = \frac{r_i \cdot \left( \dot{X}_1 - B_{X_i} \right)}{N^{shift_i}} + B_y;$$

where *shift$_i$* represents the first adaptive quantization factor, $r_i$ represents the second adaptive quantization factor, $\dot{X}_1$ represents a result of the first quantization performed on said each original input tensor $X_i$, $B_{X_i}$ represents the quantization offset calculated for the result of the first quantization performed on $X_i$, and $B_y$ represents the comprehensive quantization offset.

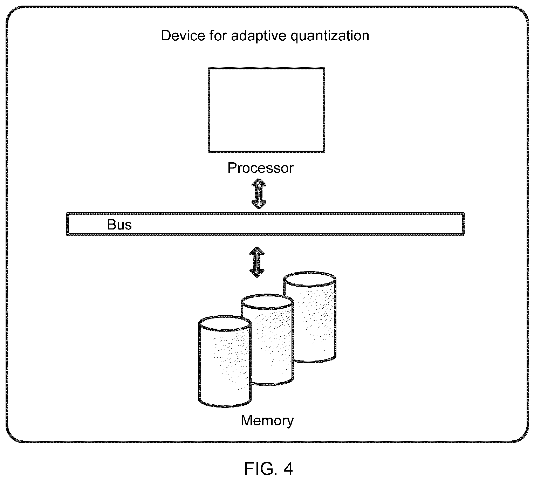

FIG. 4 is a schematic structural diagram of a device for adaptive quantization corresponding to FIG. 1 according to some embodiments of the present disclosure. The device includes:

> at least one processor; and
> a memory communicatively connected to the at least one processor;
> where the memory has stored therein instructions executable by the at least one processor, the instructions, when executed by the at least one processor, causing the at least one processor to:
>
> > for each original input tensor among the plurality of original input tensors, determine an end value of said each original input tensor, perform the first quantization on said each original input tensor based on the end value to acquire the input tensor in the fixed-point number format, and calculate the quantization offset of the input tensor in the fixed-point number format;
> >
> > determine a comprehensive end value based on respective end values of the plurality of original input tensors;
> >
> > calculate a comprehensive quantization scaling factor and the comprehensive quantization offset based on the comprehensive end value; and
> >
> > calculate the adaptive quantization factor based on the comprehensive quantization scaling factor and a quantization scaling factor adopted in the first quantization; and

perform a second quantization on the input tensor in the fixed-point number format and the quantization offset thereof based on the adaptive quantization factor and the comprehensive quantization offset to acquire a quantization result.

Some embodiments of the present disclosure provide a non-volatile computer storage medium for adaptive quantization corresponding to FIG. 1, which has stored therein computer-executable instructions, the computer-executable instructions being configured to:

for each original input tensor among the plurality of original input tensors, determine an end value of said each original input tensor, perform the first quantization on said each original input tensor based on the end value to acquire the input tensor in the fixed-point number format, and calculate the quantization offset of the input tensor in the fixed-point number format;

determine a comprehensive end value based on respective end values of the plurality of original input tensors;

calculate a comprehensive quantization scaling factor and the comprehensive quantization offset based on the comprehensive end value; and

calculate the adaptive quantization factor based on the comprehensive quantization scaling factor and a quantization scaling factor adopted in the first quantization; and

perform a second quantization on the input tensor in the fixed-point number format and the quantization offset thereof based on the adaptive quantization factor and the comprehensive quantization offset to acquire a quantization result.

The respective embodiments of the present disclosure are described in a progressive manner. The reference may be made to each other for the same or similar parts of the respective embodiments, and each embodiment focuses on the differences from other embodiments. Especially, for the embodiments of the apparatus, device and medium, since they basically correspond to the embodiments of the method, they are described in a simple way, and reference may be made to the description part on embodiments of the method for relevant points.

The apparatus, device and medium according to embodiments of the present disclosure correspond to the method one by one. Thus, the apparatus, device and medium have similar beneficial technical effects with the corresponding method. Since the beneficial technical effects of the method have been described in detail above, the beneficial technical effects of the apparatus, device, and medium will not be repeated here.

Those skilled in the art should understand that the embodiments of the present disclosure may be provided as a method, a system, or a computer program product. Therefore, the present disclosure may be in the form of full hardware embodiments, full software embodiments, or a combination thereof. Moreover, the present disclosure may be in the form of a computer program product that is implemented on one or more computer-usable storage medium (which includes, but is not limited to, magnetic disk storage, CD-ROM, optical storage) containing computer-usable program codes.

The present disclosure is described referring to the flowchart and/or block diagram of the method, device (system) and computer program product according to the embodiments of the present disclosure. It should be understood that, each flow and/or block in the flowchart and/or block diagram and the combination of flow and/or block in the flowchart and/or block diagram may be realized via computer program instructions. Such computer program instructions may be provided to the processor of a general-purpose computer, special-purpose computer, a built-in processor or other programmable data processing devices to produce a machine, such that the instructions executed by the processor of a computer or other programmable data processing devices may produce a device for realizing the functions specified in one or more flows in the flowchart and/or one or more blocks in the block diagram.

Such computer program instructions may also be stored in a computer-readable storage that can guide a computer or other programmable data processing devices to work in a specific mode, such that the instructions stored in the computer-readable storage may produce a manufacture including a commander equipment, where the commander equipment may realize the functions specified in one or more flows of the flowchart and one or more blocks in the block diagram.

Such computer program instructions may also be loaded to a computer or other programmable data processing devices, such that a series of operational processes may be executed on the computer or other programmable devices to produce a computer-realized processing, and thereby the instructions executed on the computer or other programmable devices may provide a process for realizing the functions specified in one or more flows in the flowchart and/or one or more blocks in the block diagram.

In a typical configuration, the computing device includes one or more processors (CPU), an input/output interface, a network interface, and a memory.

The memory may include a non-permanent memory in a computer-readable medium, a random access memory (RAM) and/or a non-volatile memory, such as a read-only memory (ROM) or a flash memory (flash RAM). The memory is an example of a computer-readable medium.

The computer-readable medium may be permanent and non-permanent, or removable and non-removable media, which can achieve the information storage by any method or technology. The information may be computer-readable instructions, data structures, program modules, or other data. Examples of the computer storage medium include, but are not limited to, a phase change memory (PRAM), a static random access memory (SRAM), a dynamic random access memory (DRAM), other types of random access memory (RAM), read-only memory (ROM), an electrically erasable programmable read-only memory (EEPROM), a flash memory or other memory technologies, a CD-ROM, a digital versatile disc (DVD) or other optical storage, and a magnetic cassette tape. The magnetic tape storage or other magnetic storage devices or any other non-transmission medium may be used to store information that can be accessed by computing devices. According to the definition in the present disclosure, the computer-readable medium does not include transitory media, such as modulated data signals and carrier waves.

It shall also be noted that the terms "include", "comprise" or any other variant thereof are intended to cover non-exclusive inclusion, such that a process, method, product or equipment including a series of elements not only includes those elements but also includes other elements that are not explicitly listed or elements inherent to the process, method, product, or equipment. If there are no more restrictions, the element defined by the expression "including a..." does not exclude the case where the process, method, product, or equipment further includes other identical elements in addition to the element.

Described above are only examples of the present disclosure, and are not intended to limit the present disclosure. For those skilled in the art, the present disclosure may have various modifications and changes. Any modification, equivalent replacement, improvement, or the like made according to the spirit and principle of the present disclosure shall be regarded as within the claims of the present disclosure.

**Claims**

1. A method for adaptive quantization, comprising:

    performing a first quantization on each of a plurality of original input tensors to acquire an input tensor in a fixed-point number format, and calculating a quantization offset of the input tensor in the fixed-point number format;
    calculating a comprehensive quantization offset corresponding to the plurality of original input tensors, and an adaptive quantization factor; and
    performing a second quantization on the input tensor in the fixed-point number format and the quantization offset thereof based on the adaptive quantization factor and the comprehensive quantization offset to acquire a quantization result.

2. The method according to claim 1, wherein performing the first quantization on each of the plurality of original input tensors to acquire the input tensor in the fixed-point number format and calculating the quantization offset of the input tensor in the fixed-point number format comprises:
    for each original input tensor among the plurality of original input tensors, determining an end value of said each original input tensor, performing the first quantization on said each original input tensor based on the end value to acquire the input tensor in the fixed-point number format, and calculating the quantization offset of the input tensor in the fixed-point number format.

3. The method according to claim 2, wherein calculating the comprehensive quantization offset corresponding to the plurality of original input tensors, and the adaptive quantization factor comprises:

    determining a comprehensive end value based on respective end values of the plurality of original input tensors;
    calculating a comprehensive quantization scaling factor and the comprehensive quantization offset based on the comprehensive end value; and
    calculating the adaptive quantization factor based on the comprehensive quantization scaling factor and a quantization scaling factor adopted in the first quantization.

4. The method according to claim 1, wherein the plurality of original input tensors are from a same arithmetic logic unit (ALU), and the method is executed for each of a plurality of different ALUs.

5. The method according to claim 2, wherein performing the first quantization on said each original input tensor based on the end value comprises:

    performing the first quantization on said each original input tensor with a first function based on a minimum value that is the end value and a minimum value of a specified quantized value range,
    wherein the first function comprises a quantization scaling factor, and a conversion logic for converting floating-point numbers to fixed-point numbers.

6. The method according to claim 5, wherein calculating the quantization offset of the input tensor in the fixed-point number format comprises:

> calculating the quantization offset of the input tensor in the fixed-point number format with a second function based on the minimum value that is the end value and the minimum value of the specified quantized value range,
> wherein the second function comprises the quantization scaling factor, and the conversion logic for converting floating-point numbers to fixed-point numbers.

7. The method according to claim 5 or 6, wherein the quantization scaling factor is calculated based on the end value and/or an end value of the specified quantized value range.

8. The method according to claim 3, wherein calculating the comprehensive quantization scaling factor and the comprehensive quantization offset based on the comprehensive end value comprises:
calculating the comprehensive quantization scaling factor and the comprehensive quantization offset based on the comprehensive end value and an end value of a specified quantized value range.

9. The method according to claim 3, wherein calculating the adaptive quantization factor based on the comprehensive quantization scaling factor and the quantization scaling factor adopted in the first quantization comprises:

> performing transformation on a proportional relationship between the comprehensive quantization scaling factor and the quantization scaling factor adopted in the first quantization by using a logarithmic coordinate system; and
> calculating at least one adaptive quantization factor based on the transformed proportional relationship;
> wherein a conversion logic for converting floating-point numbers to fixed-point numbers and/or a factor for preserving precision are adopted during the calculating.

10. The method according to claim 7, wherein the quantization scaling factor is calculated according to Formula

$$S_{X_i} = \frac{Q_{high} - Q_{low}}{X_{maxi} - X_{mini}}$$

, wherein $S_{X_i}$ represents the quantization scaling factor corresponding to said each original input tensor denoted as $X_i$, $Q_{low}$ represents the minimum value of the specified quantized value range, $Q_{high}$ represents a maximum value of the specified quantized value range, $X_{mini}$ rep-

resents a minimum value of $X_i$, and $X_{maxi}$ represents a maximum value of $X_i$.

11. The method according to claim 5, wherein the first function is expressed as:

$$\dot{X}_1 = round\left[ S_{X_i} \cdot \left( X_i - X_{mini} \right) \right] + Q_{low};$$

wherein $\dot{X}_1$ represents a result of the first quantization performed on said each original input tensor denoted as $X_i$, $X_{mini}$ represents a minimum value of $X_i$, $S_{X_i}$ represents the quantization scaling factor corresponding to $X_i$, $Q_{low}$ represents the minimum value of the specified quantization range, and *round* represents a function for rounding floating-point numbers to fixed-point numbers.

12. The method according to claim 6, wherein the second function is expressed as:

$$B_{X_i} = round\left[ -S_{X_i} \cdot X_{mini} \right] + Q_{low};$$

wherein $B_{X_i}$ represents the quantization offset calculated for a result of the first quantization performed on said each original input tensor denoted as $X_i$, $X_{mini}$ represents a minimum value of $X_i$, $S_{X_i}$ represents the quantization scaling factor corresponding to $X_i$, $Q_{low}$ represents the minimum value of the quantized value range, and *round* represents a function for rounding floating-point numbers to fixed-point numbers.

13. The method according to claim 9, wherein the at least one adaptive quantization factor comprises a first adaptive quantization factor and a second adaptive quantization factor;

> wherein the first adaptive quantization factor is calculated by performing transformation on the proportional relationship by using the logarithmic coordinate system and then performing precision adjustment by using the factor for preserving precision, and/or
> the second adaptive quantization factor is calculated by performing reverse transformation based on the proportional relationship and the first adaptive quantization factor by using an exponential coordinate system.

14. The method according to claim 13, wherein the first quantization is performed based on a specified bit number of an *N*-nary number, and the first adaptive quantization factor denoted as *shift$_i$* is calculated according to following Formula:

$$shift_i = ceil\left[\log_N\left(\frac{S_{X_i}}{S_y}\right)+\alpha\right];$$

wherein $S_{X_i}$ represents the quantization scaling factor corresponding to said each original input tensor denoted as $X_i$, $S_y$ represents the comprehensive quantization scaling factor, $\alpha$ represents an $N$-nary bit number expected to preserve the precision, and *ceil* represents a function for rounding up to the nearest integer.

15. The method according to claim 13, wherein the first quantization is performed based on a specified bit number of an $N$-nary number, and the second adaptive quantization factor denoted as $r_i$ is calculated according to following Formula:

$$r_i = round\left(\frac{N^{shift_i} \cdot S_{X_i}}{S_y}\right);$$

wherein $S_{X_i}$ represents the quantization scaling factor corresponding to said each original input tensor denoted as $X_i$, $S_y$ represents the comprehensive quantization scaling factor, $shift_i$ represents the first adaptive quantization factor, and *round* represents a function for rounding floating-point numbers to fixed-point numbers.

16. The method according to any one of claims 13-15, wherein the first quantization is performed according to the specified bit number of the $N$-nary number, and performing the second quantization on the input tensor in the fixed-point number format and the quantization offset thereof based on the adaptive quantization factor and the comprehensive quantization offset to acquire the quantization result comprises: performing the second quantization on the input tensor in the fixed-point number format and the quantization offset thereof according to following Formula to acquire the quantization result denoted as $\dot{Y}_1$:

$$\dot{Y}_1 = \frac{r_i \cdot \left(\dot{X}_1 - B_{X_i}\right)}{N^{shift_i}} + B_y;$$

wherein $shift_i$ represents the first adaptive quantization factor, $r_i$ represents the second adaptive quantization factor, $\dot{X}_1$ represents a result of the first quantization performed on said each original input tensor denoted as $X_i$, $B_{X_i}$ represents the quantization offset calculated for a result of the first quantization performed on $X_i$, and $B_y$ represents the comprehensive quantization offset.

17. An apparatus for adaptive quantization, comprising:

a first quantization module configured to perform a first quantization on each of a plurality of original input tensors to acquire an input tensor in a fixed-point number format, and calculate a quantization offset of the input tensor in the fixed-point number format;
an adaptive-quantization-factor calculation module configured to calculate a comprehensive quantization offset corresponding to the plurality of original input tensors, and an adaptive quantization factor; and
a second quantization module configured to perform a second quantization on the input tensor in the fixed-point number format and the quantization offset thereof based on the adaptive quantization factor and the comprehensive quantization offset to acquire a quantization result.

18. The apparatus according to claim 17, wherein performing, by the first quantization module, the first quantization on each of the plurality of original input tensors to acquire the input tensor in the fixed-point number format and calculating the quantization offset of the input tensor in the fixed-point number format comprises:
for each original input tensor among the plurality of original input tensors, determining, by the first quantization module, an end value of said each original input tensor, performing the first quantization on said each original input tensor based on the end value to acquire the input tensor in the fixed-point number format, and calculating the quantization offset of the input tensor in the fixed-point number format.

19. The apparatus according to claim 18, wherein calculating, by the adaptive-quantization-factor calculation module, the comprehensive quantization offset corresponding to the plurality of original input tensors, and the adaptive quantization factor comprises:

determining, by the adaptive-quantization-factor calculation module, a comprehensive end value based on respective end values of the plurality of original input tensors;
calculating a comprehensive quantization scaling factor and the comprehensive quantization offset based on the comprehensive end value; and
calculating the adaptive quantization factor based on the comprehensive quantization scaling factor and a quantization scaling factor adopted in the first quantization.

20. The apparatus according to claim 17, wherein the plurality of original input tensors are from a same arithmetic logic unit (ALU), and the apparatus is configured for each of a plurality of different ALUs.

21. The apparatus according to claim 18, wherein performing, by the first quantization module, the first quantization on said each original input tensor based on the end value comprises:

performing, by the first quantization module, the first quantization on said each original input tensor with a first function based on a minimum value that is the end value and a minimum value of a specified quantized value range, wherein the first function comprises a quantization scaling factor, and a conversion logic for converting floating-point numbers to fixed-point numbers.

22. The apparatus according to claim 21, wherein calculating, by the first quantization module, the quantization offset of the input tensor in the fixed-point number format comprises:

calculating by the first quantization module, the quantization offset of the input tensor in the fixed-point number format with a second function based on the minimum value that is the end value and the minimum value of the specified quantized value range, wherein the second function comprises the quantization scaling factor, and the conversion logic for converting floating-point numbers to fixed-point numbers.

23. The apparatus according to claim 21 or 22, wherein the quantization scaling factor is calculated based on the end value and/or an end value of the specified quantized value range.

24. The apparatus according to claim 19, wherein calculating, by the adaptive-quantization-factor calculation module, the comprehensive quantization scaling factor and the comprehensive quantization offset based on the comprehensive end value comprises: calculating, by the adaptive-quantization-factor calculation module, the comprehensive quantization scaling factor and the comprehensive quantization offset based on the comprehensive end value and an end value of a specified quantized value range.

25. The apparatus according to claim 19, wherein calculating, by the adaptive-quantization-factor calculation module, the adaptive quantization factor based on the comprehensive quantization scaling factor and the quantization scaling factor adopted in the first quantization comprises:

performing, by the adaptive-quantization-factor calculation module, transformation on a proportional relationship between the comprehensive quantization scaling factor and the quantization scaling factor adopted in the first quantization by using a logarithmic coordinate system; and calculating at least one adaptive quantization factor based on the transformed proportional relationship; wherein a conversion logic for converting floating-point numbers to fixed-point numbers and/or a factor for preserving precision are adopted during the calculating.

26. The apparatus according to claim 23, wherein the quantization scaling factor is calculated according to Formula
$$S_{X_i} = \frac{Q_{high} - Q_{low}}{X_{maxi} - X_{mini}}$$
, wherein $S_{X_i}$ represents the quantization scaling factor corresponding to said each original input tensor denoted as $X_i$, $Q_{low}$ represents the minimum value of the specified quantized value range, $Q_{high}$ represents a maximum value of the specified quantized value range, $X_{mini}$ represents a minimum value of $X_i$, and $X_{maxi}$ represents a maximum value of $X_i$.

27. The apparatus according to claim 21, wherein the first function is expressed as:

$$\dot{X}_1 = round\left[ S_{X_i} \cdot (X_i - X_{mini}) \right] + Q_{low};$$

wherein $\dot{X}_1$ represents a result of the first quantization performed on said each original input tensor denoted as $X_i$, $X_{mini}$ represents a minimum value of $X_i$, $S_{X_i}$ represents the quantization scaling factor corresponding to $X_i$, $Q_{low}$ represents the minimum value of the specified quantization range, and *round* represents a function for rounding floating-point numbers to fixed-point numbers.

28. The apparatus according to claim 22, wherein the second function is expressed as:

$$B_{X_i} = round\left[ -S_{X_i} \cdot X_{mini} \right] + Q_{low};$$

wherein $B_{X_i}$ represents the quantization offset calculated for a result of the first quantization performed on said each original input tensor denoted as $X_i$, $X_{mini}$ represents a minimum value of $X_i$, $S_{X_i}$ represents the quantization scaling factor corresponding to $X_i$, $Q_{low}$ represents the minimum value of the quantized value range, and *round* represents a function for rounding floating-point numbers to fixed-point numbers.

**29.** The apparatus according to claim 25, wherein the at least one adaptive quantization factor comprises a first adaptive quantization factor and a second adaptive quantization factor;

wherein the first adaptive quantization factor is calculated by the adaptive-quantization-factor calculation module performing transformation on the proportional relationship by using the logarithmic coordinate system and then performing precision adjustment by using the factor for preserving precision, and/or the second adaptive quantization factor is calculated by the adaptive-quantization-factor calculation module performing reverse transformation based on the proportional relationship and the first adaptive quantization factor by using an exponential coordinate system.

**30.** The apparatus according to claim 29, wherein the first quantization is performed based on a specified bit number of an $N$ -nary number, and the first adaptive quantization factor denoted as $shift_i$ is calculated by the adaptive-quantization-factor calculation module according to following Formula:

$$shift_i = ceil\left[ log_N\left( \frac{S_{X_i}}{S_y} \right) + \alpha \right];$$

wherein $S_{X_i}$ represents the quantization scaling factor corresponding to said each original input tensor denoted as $X_i$, $S_y$ represents the comprehensive quantization scaling factor, $\alpha$ represents an $N$ -nary bit number expected to preserve the precision, and *ceil* represents a function for rounding up to the nearest integer.

**31.** The apparatus according to claim 29, wherein the first quantization is performed based on a specified bit number of an $N$-nary number, and the second adaptive quantization factor $r_i$ is calculated by the adaptive-quantization-factor calculation module according to following Formula:

$$r_i = round\left( \frac{N^{shift_i} \cdot S_{X_i}}{S_y} \right);$$

wherein $S_{X_i}$ represents the quantization scaling factor corresponding to said each original input tensor denoted as $X_i$, $S_y$ represents the comprehensive quantization scaling factor, $shift_i$ represents the first adaptive quantization factor, and *round* represents a function for rounding floating-point numbers to fixed-point numbers.

**32.** The method according to any one of claims 29-31, wherein the first quantization is performed according to the specified bit number of the $N$ -nary number, and performing, by the second quantization module, the second quantization on the input tensor in the fixed-point number format and the quantization offset thereof based on the adaptive quantization factor and the comprehensive quantization offset to acquire the quantization result comprises:
performing, by the second quantization module, the second quantization on the input tensor in the fixed-point number format and the quantization offset thereof according to following Formula to acquire the quantization result denoted as $\dot{Y}_1$:

$$\dot{Y}_1 = \frac{r_i \cdot \left( \dot{X}_1 - B_{X_i} \right)}{N^{shift_i}} + B_y;$$

wherein $shift_i$ represents the first adaptive quantization factor, $r_i$ represents the second adaptive quantization factor, $\dot{X}_1$ represents a result of the first quantization performed on said each original input tensor denoted as $X_i$, $B_{X_i}$ represents the quantization offset calculated for the result of the first quantization performed on $X_i$, and $B_y$ represents the comprehensive quantization offset.

**33.** A device for adaptive quantization, comprising:

at least one processor; and
a memory communicatively connected to the at least one processor;
wherein the memory has stored therein instructions executable by the at least one processor, the instructions, when executed by the at least one processor, causing the at least one processor to:

perform a first quantization on each of a plurality of original input tensors to acquire an input tensor in a fixed-point number format, and calculate a quantization offset of the input tensor in the fixed-point number format;
calculate a comprehensive quantization offset corresponding to the plurality of original input tensors, and an adaptive quantization factor; and
perform a second quantization on the input tensor in the fixed-point number format and the quantization offset thereof based on the adaptive quantization factor and the comprehensive quantization offset to acquire a quantization result.

**34.** A non-volatile computer storage medium for adaptive quantization, having stored therein computer-executable instructions, wherein the computer-executable instructions are configured to:

perform a first quantization on each of a plurality of original input tensors to acquire an input tensor in a fixed-point number format, and calculate a quantization offset of the input tensor in the fixed-point number format;

calculate a comprehensive quantization offset corresponding to the plurality of original input tensors, and an adaptive quantization factor; and

perform a second quantization on the input tensor in the fixed-point number format and the quantization offset thereof based on the adaptive quantization factor and the comprehensive quantization offset to acquire a quantization result.

S102

| |
|---|
| Performing a first quantization on each of a plurality of original input tensors to acquire an input tensor in a fixed-point number format, and calculating a quantization offset of the input tensor in the fixed-point number format |

S104

| |
|---|
| Calculating a global quantization offset corresponding to the plurality of original input tensors, and an adaptive quantization factor |

S106

| |
|---|
| Performing a second quantization on the input tensor in the fixed-point number format and the quantization offset thereof based on the adaptive quantization factor and the global quantization offset to acquire a quantization result |

FIG. 1

S202

For each original input tensor among the plurality of original input tensors, determining an end value of said each original input tensor, performing the first quantization on said each original input tensor based on the end value to acquire the input tensor in the fixed-point number format, and calculating the quantization offset of the input tensor in the fixed-point number format

S204

Determining a global end value based on respective end values of the plurality of original input tensors

S206

Calculating a global quantization scaling factor and the global quantization offset based on the global end value

S208

Calculating the adaptive quantization factor based on the global quantization scaling factor and a quantization scaling factor adopted in the first quantization

S210

Performing a second quantization on the input tensor in the fixed-point number format and the quantization offset thereof based on the adaptive quantization factor and the global quantization offset to acquire a quantization result

FIG. 2

Apparatus for adaptive quantization

301    302    303

First quantization module

Adaptive-quantization-factor calculation module

Second quantization module

FIG. 3

Device for adaptive quantization

Processor

Bus

Memory

FIG. 4

## INTERNATIONAL SEARCH REPORT

| International application No. |
|---|
| **PCT/CN2019/106084** |

**A. CLASSIFICATION OF SUBJECT MATTER**

G06N 3/08(2006.01)i

According to International Patent Classification (IPC) or to both national classification and IPC

**B. FIELDS SEARCHED**

Minimum documentation searched (classification system followed by classification symbols)

G06N

Documentation searched other than minimum documentation to the extent that such documents are included in the fields searched

Electronic data base consulted during the international search (name of data base and, where practicable, search terms used)

WPI, EPODOC, CNPAT, CNKI, IEEE: 张量, 量化, 系数, 偏移, 偏置, 定点, 浮点, tensor, quantization, coefficient, shift, difference, fixed, point, float

**C. DOCUMENTS CONSIDERED TO BE RELEVANT**

| Category* | Citation of document, with indication, where appropriate, of the relevant passages | Relevant to claim No. |
|---|---|---|
| A | CN 107480770 A (INSTITUTE OF AUTOMATION, CHINESE ACADEMY OF SCIENCES) 15 December 2017 (2017-12-15) abstract, and description, paragraphs [0039]-[0072] and [0075]-[0079] | 1-34 |
| A | CN 106611216 A (BEIJING KUANGSHI TECHNOLOGY CO., LTD. et al.) 03 May 2017 (2017-05-03) entire document | 1-34 |
| A | CN 106855952 A (BEIJING KUANGSHI TECHNOLOGY CO., LTD. et al.) 16 June 2017 (2017-06-16) entire document | 1-34 |
| A | CN 107247575 A (SHANGHAI DATACENTER SCIENCE CO., LTD.) 13 October 2017 (2017-10-13) entire document | 1-34 |
| A | CN 108805796 A (INTEL CORPORATION) 13 November 2018 (2018-11-13) entire document | 1-34 |
| A | US 2018314940 A1 (INTEL CORPORATION) 01 November 2018 (2018-11-01) entire document | 1-34 |

☐ Further documents are listed in the continuation of Box C.     ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **03 December 2019** | **18 December 2019** |

| Name and mailing address of the ISA/CN | Authorized officer |
|---|---|
| **China National Intellectual Property Administration No. 6, Xitucheng Road, Jimenqiao Haidian District, Beijing 100088 China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.

**PCT/CN2019/106084**

| Patent document cited in search report | | | Publication date (day/month/year) | Patent family member(s) | | | Publication date (day/month/year) |
|---|---|---|---|---|---|---|---|
| CN | 107480770 | A | 15 December 2017 | None | | | |
| CN | 106611216 | A | 03 May 2017 | None | | | |
| CN | 106855952 | A | 16 June 2017 | None | | | |
| CN | 107247575 | A | 13 October 2017 | WO | 2018223517 | A1 | 13 December 2018 |
| | | | | US | 2019129692 | A1 | 02 May 2019 |
| CN | 108805796 | A | 13 November 2018 | US | 2018322607 | A1 | 08 November 2018 |
| | | | | DE | 102018110687 | A1 | 08 November 2018 |
| US | 2018314940 | A1 | 01 November 2018 | None | | | |

Form PCT/ISA/210 (patent family annex) (January 2015)